# EUROPEAN PATENT APPLICATION

(11) **EP 4 552 846 A1**
(43) Date of publication of application: **14.05.2025**
(21) Application number: 23275160.2
(22) Date of filing: 13.11.2023
(51) Int. Cl.: B33Y 80/00, F28F 13/08, F28F 3/02, F28F 1/12

(54) **LANCED OFFSET HEAT EXCHANGE FIN PACK DESIGN**

(71) Applicant: Hamilton Sundstrand Corporation, Charlotte, NC 28277 (US)
(72) Inventor: LaROCCA, Antonino, Edwalton, NG12 4JD (GB); DAY, Aaron Christopher, Sevenoaks, TN15 8QT (GB)
(74) Representative: Dehns

(57) **Abstract**

A heat exchange fin pack comprising: a plurality of rows of channel sections, each row comprising a plurality of adjacent legs, with each pair of adjacent legs Connected to each other by, alternately, an upper crest part and a lower peak part, the legs and the upper crest part or the lower peak part defining, therebetween a channel section for fluid flow therethrough; and wherein the channel sections of each row are offset in a direction substantially transverse to the direction of flow from the adjacent channel sections of adjacent rows, thus forming a lanced offset fin pack in which the channel sections of adjacent rows combine to form staggered flow channels; and wherein each channel section is formed to have a region of restricted diameter compared to another or other regions of that channel section.

## Description

### TECHNICAL FIELD

The present disclosure relates to a lanced offset heat sink or heat exchanger fin pack design.

### BACKGROUND

Heat sinks and heat exchangers are used in many fields and exist in many forms. The increasingly high power density demand in modern power systems requires effective removal of large heat loads whilst being under space constraints and having limited available heat exchange surfaces. Typically, heat sinks comprise a heat sink plate adjacent the system to be cooled and a fin pack, in thermal contact with the plate, the fin pack defining a flow channel for a cooling fluid. The fins provide an increased surface area for the cooling fluid and heat is transferred between the fluid and the system via the heat sink plate. Similarly, heat exchangers involve the transfer of heat between a first and a second fluid flowing in adjacent channels or layers of the heat exchanger. Many heat exchanger designs have a flowpath defined between an inlet of the heat exchanger and an outlet of the heat exchanger, and between fluid flow layers separated by plates that extend between the inlet and outlet. Heat exchange to or from a fluid flowing in the flowpath occurs primarily through the plates. It is known to provide pins or fins that extend in the flowpath, between the plates, to improve the heat transfer and create turbulence in the fluid flow. Such fins increase the surface area of the flow channel and also provide a surface against which the fluid flowing through the channel impacts, to provide enhanced heat transfer results. Various pin or fin shapes are known in heat sinks and heat exchangers, including triangular or rectangular cross-sectional shapes, wavy pins, louvred fins and lanced offset fins. All of these forms are designed to maximise the heat transfer area and optimize convective heat transfer. Lanced offset fins have found favour in many applications due to their high efficacy within a relatively small space, and the relatively low pressure drop from one end of the flow channel to the other.

Whilst lanced offset fin designs are generally known as being one of the best performing designs, there is still a desire to improve the efficacy of heat extraction from power modules. Furthermore, known methods of manufacture of such lanced offset fins, including the use of dies or stitching machine are relatively time consuming and complex and impose constraints on the length and other dimensions of the fins. There is, therefore, a desire for an effective lance offset pin design and improved method of manufacture.

### SUMMARY

Accordingly, there is provided a heat exchange fin pack comprising: a plurality of rows of channel sections, each row comprising a plurality of adjacent legs, with each pair of adjacent legs Connected to each other by, alternately, an upper crest part and a lower peak part, the legs and the upper crest part or the lower peak part defining, therebetween a channel section for fluid flow therethrough; and wherein the channel sections of each row are offset in a direction substantially transverse to the direction of flow from the adjacent channel sections of adjacent rows, thus forming a lanced offset fin pack in which the channel sections of adjacent rows combine to form staggered flow channels; and wherein each channel section is formed to have a region of restricted diameter compared to another or other regions of that channel section.

Also provided is a method of manufacturing such a heat exchange fin pack using additive manufacture.

### BRIEF DESCRIPTION

Examples of the lanced offset fin design and a method of manufacturing the lanced offset fin will be described further with reference to the drawings. It should be noted that these are examples only and that variations are possible within the scope of the claims.
Figure 1 shows an example of a conventional lanced offset fin for the purposes of background.
Figure 2A shows component parts of a heat sink incorporating a fin as shown in Fig. 1, again for background.
Figure 2B is a detail of the fin pack of Fig. 2A.
Figure 2C shows the parts of Fig. 2A in an assembled state.
Figure 3A shows one example of a modified offset fin design.
Figure 3B illustrates the shape of the flow path through the fin design of Fig. 3A.
Figure 4 shows an example of an alternative modified offset fin design.
Figure 5 shows an example of another alternative modified offset fin design.
Figures 6A, 6B and 6C show different views of an example of another alternative modified offset fin design.
Figure 7 shows an example of another alternative modified offset fin design.

### DETAILED DESCRIPTION

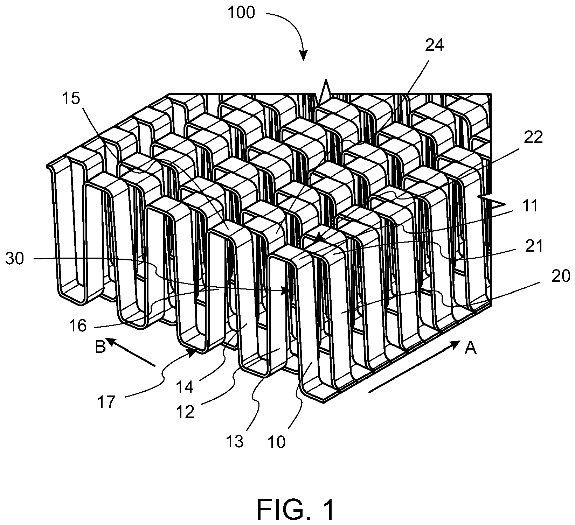

A typical lanced offset fin pack design, that can be used to define a flow path adjacent a heat sink plate or between layers of a heat exchanger is shown in Fig. 1. Fluid (cooling or heat exchange fluid) flows through the fin pack in direction A. The fin pack 100 is formed as a series of legs defined in direction B substantially transverse to the fluid flow direction, in a first row of legs 10, 12, 14, 16, a first pair of adjacent legs 10, 12, is connected by an upper peak or crest 11, the next pair of legs 12, 14 is connected by a lower peak or crest 13, the next pair of legs 14, 16 is connected by an upper peak or crest 15 and so in in direction B. Adjacent the first row of legs, in the A direction, is a second row of legs which are offset, in direction B, relative to the first row of legs. The second row of legs again has a first pair of legs 20, 22 connected by an upper peak or crest 21, a next pair of legs 22, 24 connected by a lower peak or crest and so on. The third row of legs, in the A direction is offset from the second row, in the B direction, and so may be aligned with the legs of the first row. Additional rows may be provided in the A direction providing a staggered arrangement of rows of legs. The adjacent legs and the upper peaks or crests define channels 30 having multiple staggered or offset straight sections for the flow of fluid through the fin pack in direction A. As the fluid flows through the channels, the legs provide an increased contact surface area for the fluid to exchange heat and the offset also creates turbulence in the fluid flow.

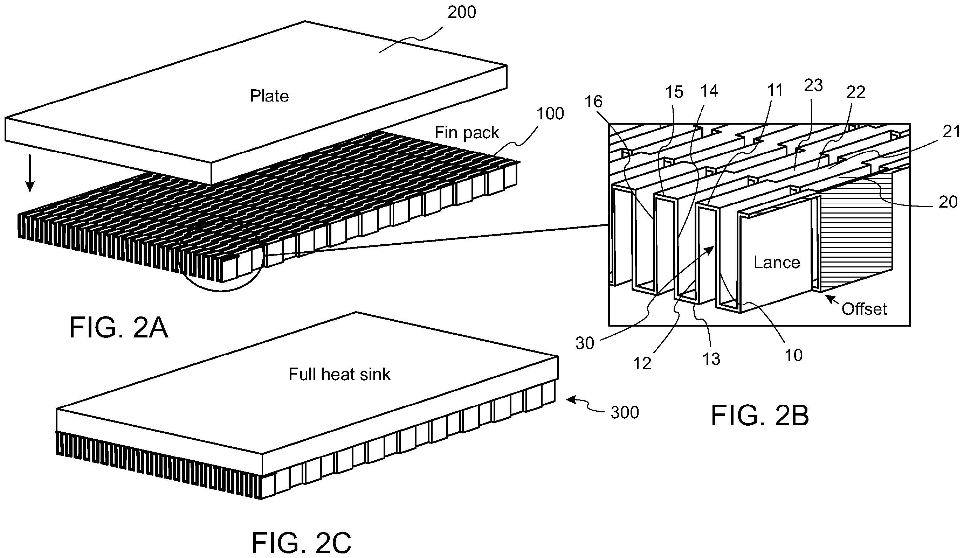

The use of such a fin pack 100 as a flow channel for a heat sink is shown in Figs. 2A to 2C, where the fin pack 100 is mounted to a heat sink plate 200 to form a complete heat sink 300.

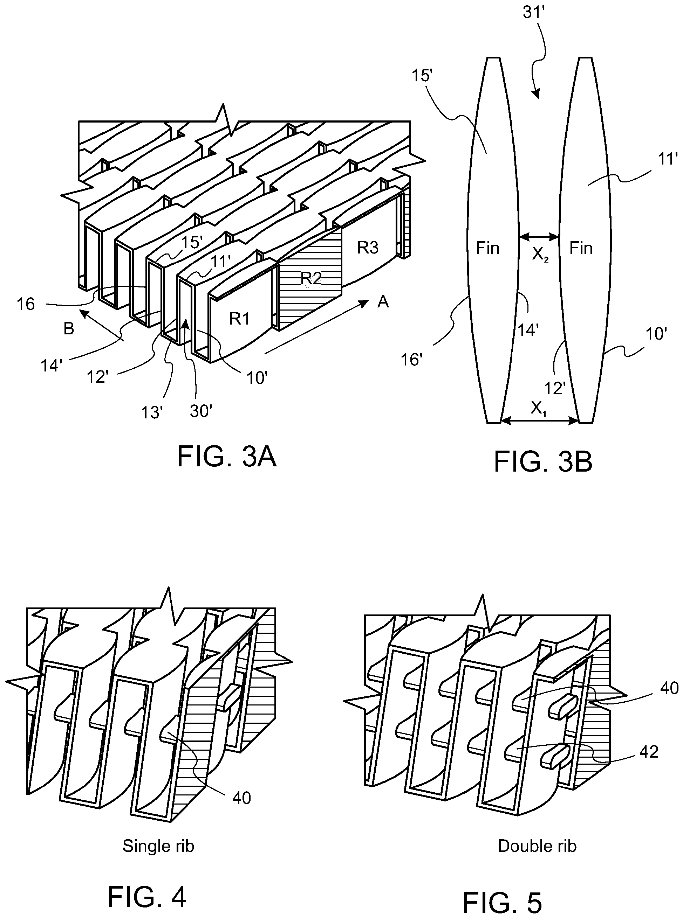

Whilst such fin packs have proven to be effective and efficacious, the present inventors have come up with a modified design that has proven to provide even better heat transfer performance. A first example is shown in Figs. 3A and 3B.

Similarly to the known design of Figs. 1 and 2A to 2C, the fin pack design comprises rows R1, R2, R3 of legs 10', 12', 14', 16' connected alternately by upper and lower peaks and crests 11', 13', 15', in the B direction, each row of legs, in the A direction, being offset relative to the previous row, and defining flow channels 30' in the A direction, rather than the legs having a straight profile in the A direction, to form straight channel sections, and the crests or peaks having a straight (rectangular) cross-section, in the modified design, the legs are formed with a profile, in the A direction, that creates a restricted cross-sectional region in the channel section 31' defined between those legs. Correspondingly, the cross-section of the peaks or crests 11', 13', 15' is not rectangular but diverges in the B direction where the channel section is restricted. In other words, the flow channel 30' still comprises a number of adjacent offset channel sections 31' in the A direction, so providing the advantages described above, but each of those sections also has a region X₂ of restricted cross-section compared to another region X₁ (or other regions, or the rest of) of that section. Whilst the profile of the legs could be one of a number of profiles that result in at least one part of the channel section having a restricted (i.e. smaller) flow channel diameter than other parts or than the rest of that section, the example shown in the Figs. has a convex curvature diverging from a first end (in direction A) outwards and then back inwards at a second end. The cross-section of the crests/peaks is, therefore ovate or elliptical and two adjacent legs 12', 14' define, between them, a channel section 31' that is wider X₁ at the ends and more restricted or narrower X₂ in a region between the ends (best seen in Fig. 3B). Compared to the flow through straight channel sections, even when offset, results have shown that the flow experiences a double flow velocity in the restricted region X₂ The fact that only a region of the channel section is restricted means that although the velocity and turbulence is increased here and so the heat transfer is improved, the pressure drop is not as great as it would be if the whole channel section had such a reduced diameter. The pressure drop is, therefore, kept manageable and acceptable for the improved flow velocity behavior.

In another example, one or more ribs 40, 42 may be provided in the channels between the legs. Fig. 4 shows an example in which one rib 40 is provided in each channel section of the fin pack. The ribs 40 provide structural support to the fin pack and also add some additional heat transfer surface to the flow channels. In addition, the ribs serve to present a further restriction to the fluid flow which enhances the convective phenomena. Fig. 5 shows an example in which two ribs 40, 42 are provided in each channel section. Other numbers of ribs are also conceivable.

Typically, using known methods of forming lanced offset fin packs, the legs are extremely thin to result in increased surface area for the overall pack size and weight. Known manufacturing processes, however, can be cost and time intensive and cannot be easily and quickly adapted to manufacture different sizes and shapes of fin according to requirements. Advances in 3D printing or additive manufacturing (AM) have allowed more and more parts to be made in a simpler, less expensive, quicker and more flexible manner and AM has many manufacturing advantages. It would, therefore, be desirable to make the modified fin pack of this disclosure using AM techniques. It is not, however, yet possible to form parts as thin as those currently used in lanced offset fin packs using AM.

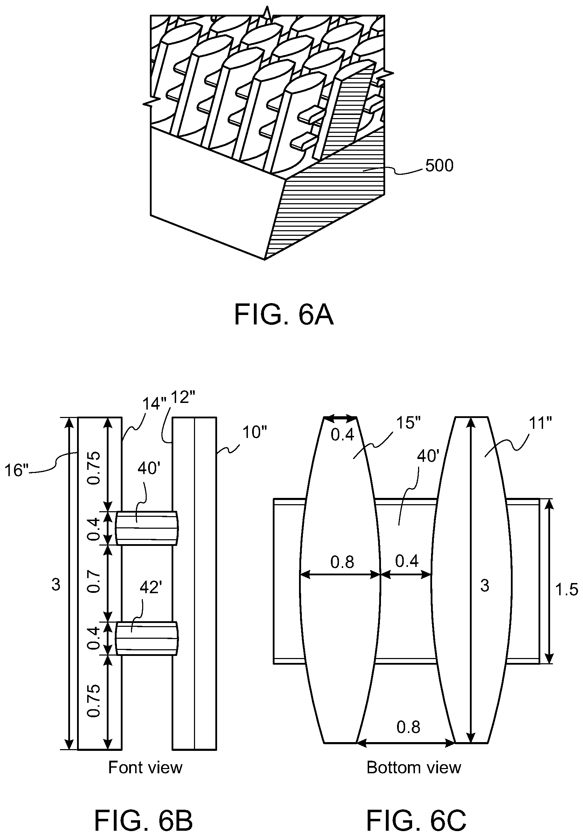

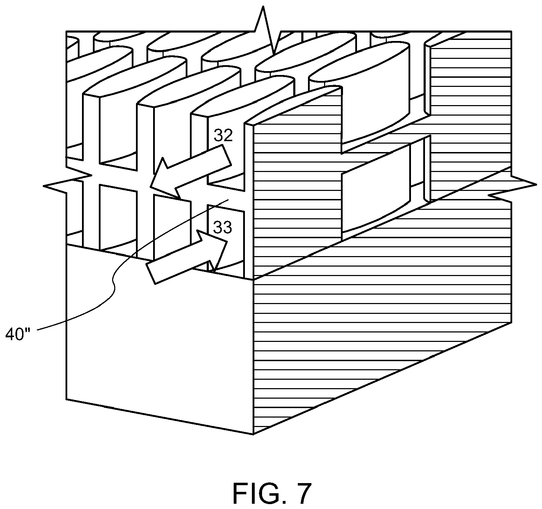

In a further modification, therefore, the present inventors have provided a design that still creates the restricted region in the channel sections, as described above, but that allows the minimum thickness of the parts to be greater than is currently the case. As an example, the peaks/crests in conventional designs currently may be in the region of 0.1 mm wide, but the modified design developed by the inventors for AM can have a width of, say, 0.4 mm. An example of the modified design that can be made using AM can be seen in Figs. 6Am which shows a section of the fin pack, Fig. 6B which shows a front view of a channel section and Fig. 6C which shows a bottom view of a channel section. Figs. 6B and 6C give some examples of dimensions (in mm) to give some idea of the size of the parts, but these are clearly examples only. In this example, the legs are also formed integrally with a base plate 500 which has the advantage of eliminating an additional thermal contact resistance. In a variation of this example, shown in Fig. 7, the ribs 40" may be formed to extend completely across the channel sections so as to define an upper flow region 32 and a lower flow region 33 in each channel section. This enables different fluids (e.g. hot and cold) to flow in counter-flow through the same channels. This design was found not to substantially increase the pressure drop, but to provide a more uniform temperature distribution between the ends of the flow channel.

## Claims

1. A heat exchange fin pack comprising:
a plurality of rows of channel sections, each row comprising a plurality of adjacent legs, with each pair of adjacent legs connected to each other by, alternately, an upper crest part and a lower peak part, the legs and the upper crest part or the lower peak part defining, therebetween a channel section for fluid flow therethrough; and
wherein the channel sections of each row are offset in a direction substantially transverse to the direction of flow from the adjacent channel sections of adjacent rows, to form a lanced offset fin pack in which the channel sections of adjacent rows combine to form staggered flow channels; and wherein
each channel section has a region of restricted diameter compared to another or other regions of that channel section.

2. The heat exchange fin pack of claim 1, where each channel section has a shape that, in the direction of flow, diverges from a first relatively wide end to a narrower intermediate region and then converges to a second relatively wide end.

3. The heat exchange fin pack of claim 2, wherein the upper crest parts and the lower peak parts have an elliptical cross-section.

4. The heat exchange fin pack of any preceding claim, further comprising one or more ribs extending across each channel section.

5. The heat exchange fin pack of claim 4, comprising two ribs extending across each channel section.

6. The heat exchange fin pack of any preceding claim, formed by additive manufacture.

7. The heat exchange fin pack of claim 6, further comprising a base plate, and wherein the plurality of rows are integral with the base plate.

8. The heat exchange fin pack of claim 6 or 7, further comprising ribs extending completely across each channel section transverse to the direction of flow, to define an upper and a lower flow portion of the channel section.

9. A heat sink comprising a heat sink plate and a heat exchange fin pack as claimed in any preceding claim in thermal contact with the heat sink plate.

10. A heat exchanger comprising an upper layer and a lower layer and a heat exchange fin pack as claimed in any of claims 1 to 8 mounted between the upper and lower layer.

11. A method of manufacturing a heat exchange fin pack as claimed in any preceding claim, comprising forming the channel sections using additive manufacturing.
